# EUROPEAN PATENT APPLICATION

(11) **EP 4 823 302 A1**
(43) Date of publication of application: **14.10.2026**
(21) Application number: 24926371.6
(22) Date of filing: 28.02.2024
(51) Int. Cl.: H10K 59/50, H10K 59/122, H10K 50/86, G02F 1/1333

(54) **DISPLAY SUBSTRATE AND DISPLAY PANEL**

(71) Applicant: Boe Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Beijing 100176 (CN)
(72) Inventor: ZENG, Cheng, Beijing 100176 (CN); WANG, Dan, Beijing 100176 (CN); YU, Guangri, Beijing 100176 (CN); WU, Huan, Beijing 100176 (CN); MA, Lulin, Beijing 100176 (CN); CHENG, Xingjian, Beijing 100176 (CN); WEI, Zhenye, Beijing 100176 (CN); WANG, Qiyun, Beijing 100176 (CN)
(74) Representative: Cohausz & Florack
(86) International application number: PCT/CN2024/079056
(87) International publication number: WO 2025/179488

(57) **Abstract**

The present disclosure provides a display substrate and a display panel, and belongs to the field of display technology. The present disclosure can solve the problem of light interference during touch detection in the existing display products. The display substrate of the present disclosure includes: a light-emitting device layer configured to emit first color light; a quantum dot layer including at least a first quantum dot unit and a second quantum dot unit, where the first quantum dot unit is configured to emit second color light under excitation of the first color light, and the second quantum dot unit is configured to emit third color light under excitation of the first color light; a touch detection layer configured to determine touch information according to a received optical signal; and an auxiliary functional layer between the quantum dot layer and the light-emitting device layer; wherein the auxiliary functional layer is configured to transmit the first color light and reflect the second color light and the third color light, so that interference with the touch detection layer is reduced, and the accuracy and sensitivity of the touch detection layer are improved.

## Description

### TECHNICAL FIELD

The present disclosure relates to the field of display technology, and specifically relates to a display substrate and a display panel.

### BACKGROUND

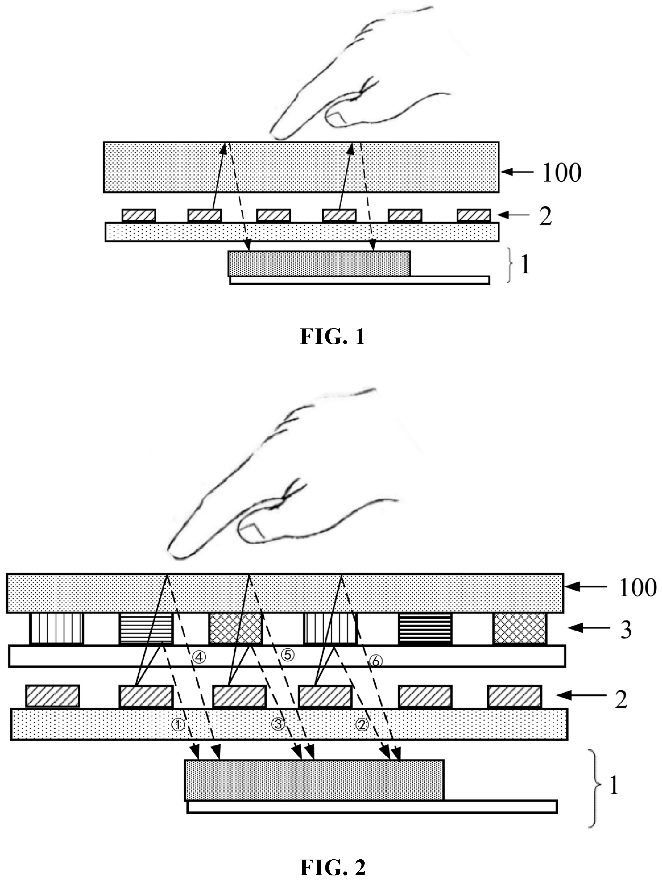

With the increased applications of the organic light-emitting diode (OLED) display screen, optical in-display fingerprint identification is more widely applied in smart devices. FIG. 1 is a schematic diagram of an OLED optical in-display fingerprint identification structure in the existing art. As shown in FIG. 1, the optical in-display fingerprint identification is based on the principle that when a finger presses a screen 100, light emitted from an OLED light-emitting device 2 is reflected after impinging on the finger, and a touch detection layer 1 receives the reflected light to perform fingerprint identification.

The quantum dot (QD) has the characteristics of continuously adjustable wavelength as a function of the particle size, uniform light emission, pure spectrum and the like. The OLED has the characteristics of self-luminescence, high contrast, flexibility, bendability and the like. Therefore, a product combining the two has the characteristics of high contrast, high color gamut, excellent viewing angle and the like. This technology has now been used in large-sized products, such as TVs and MNTs (Monitors). With the development of subsequent technologies, the technology may be applied to products of medium and small sizes, such as NBs (Notebook computers), TPCs (Tablet Personal Computers) and the like. The small and medium sized products also need optical in-display fingerprint identification to achieve better user experience.

However, in a QD-OLED device combining the QD and the OLED, when light emitted from the light-emitting device 2 of the OLED passes through the QD, some interference light may be generated and pass through an inside of the light-emitting device 2 to the touch detection layer 1 below, causing interference with the optical identification and reducing the identification accuracy and sensitivity.

### SUMMARY

To solve at least one of the technical problems in the existing art, the present disclosure provides a display substrate and a display panel which can improve the accuracy and sensitivity of optical identification.

In a first aspect, a technical solution adopted to solve the technical problem of the present disclosure is a display substrate, including:
a base substrate;
a light-emitting device layer on the base substrate, wherein the light-emitting device layer includes a plurality of light-emitting devices configured to emit first color light;
a quantum dot layer on a side of the light-emitting device layer facing away from the base substrate, wherein the quantum dot layer includes at least a first quantum dot unit and a second quantum dot unit, where the first quantum dot unit is configured to emit second color light under excitation of the first color light, and the second quantum dot unit is configured to emit third color light under excitation of the first color light;
a touch detection layer on a side of the light-emitting device layer facing away from the quantum dot layer, and configured to determine touch information according to a received optical signal; and
an auxiliary functional layer between the quantum dot layer and the light-emitting device layer; wherein the auxiliary functional layer is configured to transmit the first color light and reflect the second color light and the third color light.

In some embodiments, an encapsulation layer is disposed on a side of the light-emitting device layer facing away from the base substrate, and the auxiliary functional layer is disposed between the encapsulation layer and the quantum dot layer.

In some embodiments, the auxiliary functional layer includes a plurality of functional sub-layers sequentially stacked in a direction facing away from the base substrate, and in a direction pointing from the quantum dot layer to the base substrate, each functional sub-layer in an odd layer has a first refractive index, each functional sub-layer in an even layer has a second refractive index, and the first refractive index is higher than the second refractive index.

In some embodiments, the first refractive index is in a range from 1.85 to 1.95; and the second refractive index is in a range from 1.2 to 1.4.

In some embodiments, the functional sub-layer in the odd layer has a thickness in a range from 0.5µm to 2.0µm; and the functional sub-layer in the even layer has a thickness in a range from 1.0µm to 2.0µm.

In some embodiments, the display substrate includes a first subpixel, a second subpixel, and a third subpixel which emit the first color light, the second color light, and the third color light, respectively, wherein the first subpixel includes one light-emitting device; the second subpixel includes one light-emitting device and one first quantum dot unit; and the third subpixel includes one light-emitting device and one second quantum dot unit.

In some embodiments, the display substrate includes a light blocking layer on a side of the auxiliary functional layer facing away from the base substrate, wherein the light blocking layer includes a first receiving portion configured to transmit the first color light emitted from the light-emitting device in the first subpixel, a second receiving portion configured to receive the first quantum dot unit, a third receiving portion configured to receive the second quantum dot unit, and a first blocking part defining the first, second, and third receiving portions; and the first blocking part has at least one first opening running through the first blocking part in a thickness direction thereof.

In some embodiments, the display substrate is divided into a plurality of pixel units arranged in an array, each of which includes one first subpixel, one second subpixel and one third subpixel; and an opening region is defined between any four pixel units arranged in an array, and the first opening is in the opening region.

In some embodiments, orthographic projections of the first, second and third receiving portions on the base substrate each have an octagonal shape, an orthographic projection of the opening region on the base substrate has a regular decagonal shape, with the first opening provided at at least one of a center, a center of a side, a vertex, a midpoint of a connection line between the vertex and the center, or a midpoint of a connection line between the center of the side and the center, of the regular decagonal shape.

In some embodiments, a distance from the center to any vertex of the regular decagonal shape is in a range from 20µm to 50µm.

In some embodiments, the decagonal shape has an area in a range from (1/5)S to S, where S is an area of an orthographic projection of a single pixel unit on the base substrate.

In some embodiments, an orthographic projection of each first opening on the base substrate has an area in a range from (1/60)S to (1/14)S; and for first openings in one opening region, a total area of orthographic projections of the first openings on the base substrate is in a range from (1/8)S to (1/2)S.

In some embodiments, orthographic projections of the first, second and third receiving portions on the base substrate each have a rectangular shape, an orthographic projection of the opening region on the base substrate has a square shape, with the first opening provided at at least one of a center, a vertex, a center of a side, a midpoint of a connection line between the vertex and the center, a midpoint of a connection line between the vertex and the center of the side, or a midpoint of a connection line between of the center and the center of the side, the square shape.

In some embodiments, the square shape has a side length between 40µm and 120µm.

In some embodiments, the square shape has an area in a range from (1/4)S to S, where S is an area of an orthographic projection of a single pixel unit on the base substrate.

In some embodiments, an orthographic projection of each first opening on the base substrate has an area in a range from (1/100)S to (1/20)S; and for first openings in one opening region, a total area of orthographic projections of the first openings on the base substrate is in a range from (1/8)S to (1/2)S.

In some embodiments, the light-emitting device layer includes a pixel defining layer, which is a light-shielding layer, including a fourth receiving portion and a second blocking part defining the fourth receiving portion, wherein the second blocking part has a second opening arranged in one-to-one correspondence with the first opening.

In some embodiments, the display substrate further includes a color filter layer on a side of the quantum dot layer facing away from the light-emitting device layer, wherein the color filter layer includes a black matrix and a color filter; and the black matrix includes a light-transmitting part and a third blocking part defining the light-transmitting part, wherein the third blocking part has a third opening arranged in one-to-one correspondence with the first opening.

In some embodiments, the display substrate further includes a scattering particle unit received in the first receiving portion and configured to scatter the first color light.

In some embodiments, the scattering particle unit includes a first scattering particle unit and a second scattering particle unit sequentially arranged in a direction facing away from the touch detection layer, wherein a solid content of scattering particles in the first scattering particle unit is in a range from 1% to 2%; and a solid content of scattering particles in the second scattering particle unit is in a range from 4% to 8%.

In some embodiments, the scattering particle unit includes a first scattering particle unit and a second scattering particle unit sequentially arranged in a direction facing away from the touch detection layer, wherein a thickness of the first scattering particle unit is in a range from (1/2)h to (4/5)h; and a thickness of the second scattering particle unit is in a range from (1/5)h to (1/2)h, where h is a total thickness of the scattering particle unit.

In some embodiments, the scattering particle unit includes a first scattering particle unit, a second scattering particle unit, and a third scattering particle unit sequentially arranged in a direction facing away from the touch detection layer, wherein a solid content of scattering particles in the first scattering particle unit is in a range from 1% to 2%; and a solid content of scattering particles in the second scattering particle unit is in a range from 2% to 4%; and a solid content of scattering particles in the third scattering particle unit is in a range from 4% to 6%.

In some embodiments, the scattering particle unit includes a first scattering particle unit, a second scattering particle unit, and a third scattering particle unit sequentially arranged in a direction facing away from the touch detection layer, wherein a thickness of the first scattering particle unit is in a range from (1/3)h to (1/2)h; a thickness of the second scattering particle unit is in a range from (1/6)h to (1/3)h; and a thickness of the third scattering particle unit is in a range from (1/3)h to (1/2)h, where h is a total thickness of the scattering particle unit.

In some embodiments, the display substrate further includes an optical clear adhesive unit received in the first receiving portion.

In some embodiments, the display substrate further includes a color filter layer on a side of the quantum dot layer facing away from the light-emitting device layer, wherein the color filter layer includes a black matrix and a first structure, a second color filter and a third color filter; the second color filter is arranged in one-to-one correspondence with the first quantum dot unit; the third color filter is arranged in one-to-one correspondence with the second quantum dot unit; the first structure is arranged in one-to-one correspondence with the optical clear adhesive unit; and
the first structure is further configured to scatter the first color light.

In some embodiments, the first structure is made of a mixture of a material of a first color filter and a material of scattering particles, and a solid content of the scattering particles is in a range from 6% to 8%.

In some embodiments, the first structure includes a first color filter unit and a scattering particle unit sequentially arranged in a direction facing away from the quantum dot layer.

In some embodiments, a thickness of the scattering particle unit is greater than or equal to a thickness of the first color filter unit.

In a second aspect, an embodiment of the present disclosure further provides a display panel, including any display substrate as described in the first aspect.

### BRIEF DESCRIPTION OF DRAWINGS

FIG. 1 is a schematic diagram of an OLED optical in-display fingerprint identification structure in the existing art;
FIG. 2 is a schematic diagram of a QD-OLED optical in-display fingerprint identification structure in the existing art;
FIG. 3 is a schematic diagram of a display substrate according to an embodiment of the present disclosure;
FIG. 4 is a schematic diagram showing reflectivities of an encapsulation layer at different wave bands according to an embodiment of the present disclosure;
FIG. 5 is a schematic optical path diagram of an auxiliary functional layer according to an embodiment of the present disclosure;
FIG. 6 is a schematic diagram of an LRI structure according to an embodiment of the present disclosure;
FIG. 7 is a schematic diagram showing reflectivities at different wave bands in a multiple optical film (MOF) corresponding to table 1;
FIG. 8 is a schematic diagram showing an arrangement of pixel units according to an embodiment of the present disclosure;
FIGs. 9 to 11 are schematic diagrams showing a layout of first openings according to an embodiment of the present disclosure;
FIG. 12 is a schematic diagram showing another arrangement of pixel units according to an embodiment of the present disclosure;
FIGs. 13 to 15 are schematic diagrams of still another layout of first openings according to an embodiment of the present disclosure, respectively;
FIGs. 16a to 16b are schematic diagrams of a scattering particle unit according to an embodiment of the present disclosure;
FIGs. 17a to 17b are schematic diagrams of another scattering particle unit according to an embodiment of the present disclosure;
FIG. 18 is a schematic diagram of another display substrate according to an embodiment of the present disclosure;
FIG. 19 is a schematic diagram of a first structure according to an embodiment of the present disclosure; and
FIG. 20 is a schematic diagram of another first structure according to an embodiment of the present disclosure.

### DETAIL DESCRIPTION OF EMBODIMENTS

To improve understanding of the technical solution of the present disclosure for those skilled in the art, the present disclosure will be described in detail with reference to accompanying drawings and specific implementations.

Unless otherwise defined, technical or scientific terms used in the present disclosure are intended to have general meanings as understood by those skilled in the art to which the present disclosure belongs. The words "first", "second" and similar terms used in the present disclosure do not denote any order, quantity, or importance, but are used merely for distinguishing different components from each other. Likewise, the words "a", "an", or "the" and similar referents do not denote a limitation of quantity, but rather denote the presence of at least one. The word "comprise" or "include" or the like means that the element or item preceding the word contains elements or items that appear after the word or equivalents thereof, but does not exclude other elements or items. The terms "connected" or "coupled" and the like are not restricted to physical or mechanical connection, but may include electrical connection, either direct or indirect. The words "upper", "lower", "left", "right", and the like are merely used to indicate a relative positional relationship, and when an absolute position of the described object is changed, the relative positional relationship may be changed accordingly.

FIG. 2 is a schematic diagram of a QD-OLED optical in-display fingerprint identification structure in the existing art. As shown in FIG. 2, a light-emitting device 2 emits first color light. One part of the first color light emitted from the light-emitting device 2 excites a quantum dot layer (QD layer) 3 to convert the first color light to light of a corresponding color (such as red light or green light), which is then emitted to a screen surface 100, forms reflection at a finger contact position, and passes through an inside of the light-emitting device 2 to a touch detection layer 1 below (light indicated by ④, ⑤, ⑥ in the figure) for fingerprint identification or other types of touch detection. Meanwhile, since the entire QD layer 3 emits light uniformly, the other part of the first color light emitted from the light-emitting device 2 is converted by the QD layer 3 to light of a corresponding color, then is emitted below the QD layer 3, i.e., generates light emitted downward, and passes through the inside of the light-emitting device 2 to the touch detection layer 1 below (as indicated by ①, ③, ② in the figure). This part of light is irrelevant to the touch on the screen surface 100, and thus causes interference with the touch detection layer 1 and reduces its accuracy and sensitivity.

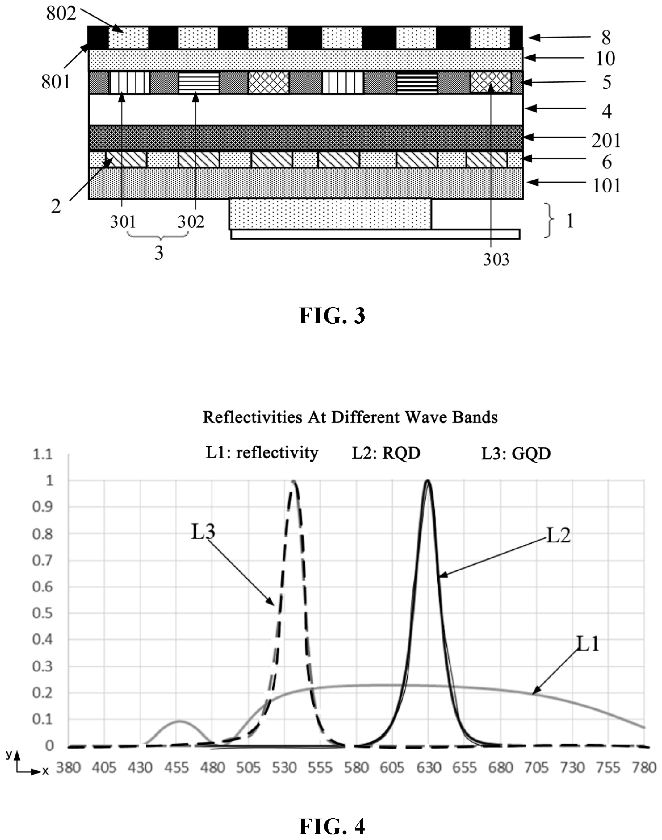

To solve the technical problem in the existing art, an embodiment of the present disclosure provides a display substrate. FIG. 3 is a schematic diagram of a display substrate according to an embodiment of the present disclosure. As shown in FIG. 3, the display substrate includes: a base substrate 101, a light-emitting device layer, a quantum dot layer 3, a touch detection layer 1, and an auxiliary functional layer 4. The light-emitting device layer is disposed on the base substrate 101, and includes a plurality of light-emitting devices 2 configured to emit first color light. The quantum dot layer 3 is disposed on a side of the light-emitting device layer facing away from the base substrate 101, and includes at least a first quantum dot unit 301 and a second quantum dot unit 302, where the first quantum dot unit 301 is configured to emit second color light under excitation of the first color light, and the second quantum dot unit 302 is configured to emit third color light under excitation of the first color light. The touch detection layer 1 is disposed on a side of the light-emitting device layer facing away from the quantum dot layer 3, and configured to determine touch information according to a received optical signal. The auxiliary functional layer 4 is disposed between the quantum dot layer 3 and the light-emitting device layer. The auxiliary functional layer 4 is configured to transmit the first color light and reflect the second color light and the third color light.

Specifically, the quantum dot layer 3 includes a plurality of quantum dot units, each of which is a semiconductor crystal particle with a size between 2nm and 10nm. When the semiconductor crystal is down to the nanometer scale, semiconductor crystal with different sizes can be excited to emit different colors of light. For example, in a case where the semiconductor nanocrystal is made of cadmium selenide, the semiconductor nanocrystal emits blue light when excited with a size of the semiconductor nanocrystal being 2nm, emits red light when excited with a size of the semiconductor nanocrystal being 8nm, and emits green, yellow or orange light when excited with a size of the semiconductor nanocrystal being other intermediate sizes. Depending on the chemical components and sizes, colors of the light emitted from the quantum dot units may cover the whole visible region from blue to red, and the emitted light has a high color purity and is continuously adjustable.

The first color light emitted from the light-emitting device 2 may be blue light. The first quantum dot unit 301 may be a red quantum dot (RQD), and the second quantum dot unit 302 may be a green quantum dot (GQD). Each light-emitting device 2 in the light-emitting device layer emits blue light, excites the RQD to form red light (second color light) and excites the GQD to form green light (third color light). Apparently, the first color light emitted from the light-emitting device 2 may alternatively be other colors of light, such as white light, red light, purple light, or the like; and the first quantum dot unit 301 and the second quantum dot unit 302 may alternatively be quantum dots of other colors, such as orange quantum dots, yellow quantum dots, or the like, depending on their chemical components and sizes, which is not limited in the present disclosure. In addition, the light-emitting device 2 may or may not be disposed in correspondence with the quantum dot unit (such as the first quantum dot unit 301 and the second quantum dot unit 302), as long as the first color light emitted from the light-emitting device 2 can excite the quantum dot unit to form light of the corresponding color.

It should be noted that, in all embodiments of the present disclosure, the case where the first color light is blue light, the first quantum dot unit 301 is a red quantum dot (RQD), and the second quantum dot unit 302 is a green quantum dot (GQD) is merely taken as an example for illustration, and does not form any limitation to the embodiments of the present disclosure.

The touch detection layer 1 is disposed below the light-emitting device layer, and configured to detect reflected light of the light emitted from the light-emitting devices 2 formed by touching, so as to determine touch information. Optionally, the touch detection layer 1 may be disposed on a side of the base substrate 101 close to the light-emitting device layer, or may be disposed on a side of the base substrate 101 facing away from the light-emitting device layer, which is not limited in the present disclosure.

Light emitted from the RQD and GQD is uniform and satisfies Lambertian distribution. When the first color light passes through the QD layer 3 to emit the second color light and the third color light, the second color light and the third color light are uniformly emitted in all directions. Therefore, a part of the second color light or the third color light will directly pass through the light-emitting devices 2 to the touch detection layer 1, which may interfere with the detection result of the touch detection layer 1 and affect its accuracy and sensitivity. In FIG. 2, the case where ③ and ⑤ correspond to the first color light, ① and ④ correspond to the second color light, and ② and ⑥ correspond to the third color light is taken as an example for illustration, and according to the embodiment corresponding to FIG. 2, ①, ② and ③ are interference light to the touch detection layer 1, and ④, ⑤ and ⑥ are light reflected by finger touch, i.e., optical signals to be detected by the touch detection layer 1.

In addition, due to different wavelengths, different colors of light have different light paths after passing through a material surface with the same reflectivity. In the embodiments of the present disclosure, an auxiliary functional layer 4 is provided to reflect the second color light and the third color light, so that interference light generated by the second color light and the third color light is reduced (for example, interference of ① and ② is reduced in FIG. 2). In one aspect, interference light (such as ① and ② in FIG. 2) from the second color light and the third color light that directly passes through the light-emitting device 2 to the touch detection layer 1 is reduced, so that the detection accuracy and sensitivity of the touch detection layer 1 are improved. In another aspect, through the reflection by the auxiliary functional layer 4, a proportion of the second color light and the third color light emitted to a screen of a display product corresponding to the display substrate is increased, thereby increasing the emission efficiency of the display product and improving the display effect. In still another aspect, the auxiliary functional layer 4 can transmit the first color light (e.g., ③ and ⑤ in FIG. 2), and ensure that the reflected light (e.g., ⑤ in FIG. 2) caused by touch can reach the touch detection layer 1 without affecting the touch detection layer 1 receiving the optical signal and determining the touch information.

In the embodiment of the present disclosure, by means of the auxiliary functional layer 4 between the quantum dot layer 3 and the light-emitting device layer, the second color light and the third color light are reflected to change light paths of the second color light and the third color light in a direction toward the touch detection layer 1, so that a proportion of the second color light and the third color light emitted to the touch detection layer 1, and the interference with the touch detection layer 1, are reduced; and meanwhile, a proportion of the second color light and the third color light emitted to the screen of the display product is increased, and the emission efficiency on a front side of the screen and the display effect are improved. In addition, the auxiliary functional layer 4 can transmit the first color light, and will not affect detection of the optical signal corresponding to the touch by the touch detection layer 1.

In some embodiments, the display substrate includes not only the base substrate 101, the light-emitting device layer, the quantum dot layer 3, the touch detection layer 1, and the auxiliary functional layer 4, but also an encapsulation layer 201. The encapsulation layer 201 is disposed on a side of the light-emitting device layer facing away from the base substrate 101, and the auxiliary functional layer 4 is disposed between the encapsulation layer 201 and the quantum dot layer 3.

Specifically, the encapsulation layer (thin film encapsulation TFE) 201 may include a single-layer or multi-layer structure mainly composed of inorganic and organic layers. Optionally, the encapsulation layer 201 includes a first inorganic thin film encapsulation layer IOL1, an organic thin film encapsulation layer OL1, and a second inorganic thin film encapsulation layer IOL2 sequentially arranged in a stack. The IOL1 may be mainly made of SiNOx, and have a thickness between 0.8µm and 1.0µm, and a refractive index between 1.70 and 1.75; the OL1 may be mainly made of methyl methacrylate (PMMA), and have a thickness between 8µm and 12µm, and a refractive index between 1.50 and 1.60; and the IOL2 may be mainly made of SiNx, and have a thickness between 0.5µm and 0.8µm, and a refractive index between 1.80 and 1.95. Optionally, the encapsulation layer 201 may be formed by a PECVD process or inkjet printing.

FIG. 4 is a schematic diagram showing reflectivities of an encapsulation layer at different wave bands according to an embodiment of the present disclosure. As shown in FIG. 4, coordinates along a first direction x represent wave bands, and coordinates along a second direction y represent reflectivities, where L1 is a reflectivity curve corresponding to different wave bands, L2 is a wave band curve corresponding to red light from the RQD, and L3 is a wave band curve corresponding to green light from the GQD. As can be seen from FIG. 4, the encapsulation layer 201 has a reflectivity of about 21% at the RQD wave band (630nm), has a reflectivity of about 20% at the GQD wave band (532nm), and has a reflectivity of about 10% at a blue wave band to which the backlight belongs (the wave band curve of blue light is not shown in FIG. 4, which is centered around 460nm). As can be seen, the encapsulation layer 201 has lower reflectivities to red light and green light, and most of the red light and the green light can still pass through the light-emitting device layer to the touch detection layer 1, causing interference with detection of the touch detection layer 1.

In the embodiment of the present disclosure, to improve the reflectivity of the film layer below the QD layer 3 to the light emitted from the R/G QD, an auxiliary functional layer 4 is disposed on a side of the existing encapsulation layer 201 facing away from the light-emitting device layer, and by adjusting a refractive index n and a film thickness of the auxiliary functional layer 4, the purpose of improving the reflectivity of the R/G QD emitted light in the auxiliary functional layer 4 can be achieved.

In some embodiments, the auxiliary functional layer 4 includes a plurality of functional sub-layers sequentially stacked in a direction facing away from the base substrate 101, and in a direction pointing from the quantum dot layer 3 to the base substrate 101, each functional sub-layer in an odd layer has a first refractive index n1, each functional sub-layer in an even layer has a second refractive index n2, and the first refractive index n1 is higher than the second refractive index n2.

Specifically, low and high refractive indexes of functional sub-layers of the auxiliary functional layer 4 are staggered to obtain more uniformly reflected light. In some embodiments, the first refractive index n1 is higher than a refractive index of the quantum dot layer 3, and the second refractive index n2 is lower than the refractive index of the quantum dot layer 3. With such arrangement, the red light and green light emitted to the auxiliary functional layer 4 can be ensured to be reflected by the auxiliary functional layer 4 to a greater extent, so that interference with the touch detection layer 1 is reduced, and the accuracy and sensitivity of the touch detection layer 1 are improved.

In some embodiments, the first refractive index is in a range from 1.85 to 1.95; and the second refractive index is in a range from 1.2 to 1.4. In some embodiments, the functional sub-layer in the odd layer has a thickness in a range from 0.5µm to 2.0µm; and the functional sub-layer in the even layer has a thickness in a range from 1.0µm to 2.0µm.

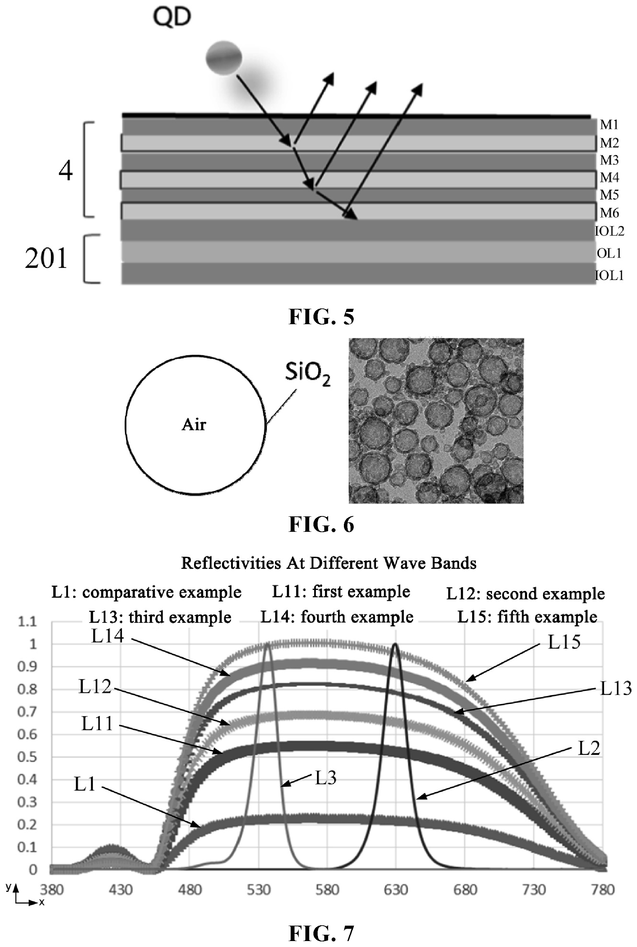

Specifically, FIG. 5 is a schematic optical path diagram of an auxiliary functional layer according to an embodiment of the present disclosure. As shown in FIG. 5, the case where the auxiliary functional layer 4 is disposed above the encapsulation layer 201, the encapsulation layer 201 includes a first inorganic encapsulation layer IOL1, an organic layer OL1, and a second inorganic encapsulation layer ILO2 sequentially arranged in the direction close to the auxiliary functional layer, and the auxiliary functional layer 4 includes six functional sub-layers, i.e., M1, M2, M3, M4, M5 and M6 sequentially arranged in a direction approaching the encapsulation layer 201, is taken as an example for illustration.

M1, M3 and M5 may each have a high refractive index in a range from 1.85 to 1.95 and a thickness between 0.5µm and 2.0µm, and be made of a material including, but not limited to, SiNx, SiNOx, TiO2, ZnO, ZrO2 or the like; while M2, M4 and M6 may each have a low refractive index in a range from 1.45 to 1.6 and a thickness between 0.5µm and 2.0µm, and be made of a material including, but not limited to, an organic material like: acrylic resin, polyurethane resin, silicone resin, silane resin, epoxy resin, or the like, or an inorganic material like: ZnO, Al2O3, SiO2, or the like.

In some embodiments, in the direction pointing from the quantum dot layer 3 to the base substrate 101, the functional sub-layer in the even layer (e.g., M2, M4 and M6 in FIG. 5) may be an organic film layer LRI doped with hollow particles.

Specifically, FIG. 6 is a schematic diagram of an LRI structure according to an embodiment of the present disclosure. As shown in FIG. 6, the left is a schematic structural diagram of a hollow particle, and the right is a schematic diagram of an organic film layer LRI. Referring to the left diagram of FIG. 6, the hollow particle has a core-shell structure, with the shell mainly composed of SiO2 and containing air therein, and a concentration of hollow particles in an organic matrix material of the organic film layer LRI is in a range from 20% to 40%. In some embodiments, the organic film layer LRI may have a refractive index in a range from 1.2 to 1.4, and a thickness between 1.0µm and 2.0µm, and the organic matrix material of the organic film layer LRI may be silane resin, epoxy resin, or the like.

It is to be understood that the materials, reflectivity values and thicknesses of odd layers in the above embodiments may be the same or different; and the materials, reflectivity values and thicknesses of even layers may be the same or different, as long as they are in the defined ranges, which are not limited in the present disclosure.

Table 1 shows correspondence between the auxiliary functional layer (MOF) 4 and the R/G/B reflectivities. FIG. 7 is a schematic diagram showing reflectivities at different wave bands in an MOF corresponding to table 1. In FIG. 7, coordinates along a first direction x represent wave bands, and coordinates along a second direction y represent reflectivities, L2 is a wave band curve corresponding to red light from the RQD, and L3 is a wave band curve corresponding to green light from the GQD. L1 is a reflectivity curve of the auxiliary functional layer (MOF) 4 corresponding to the comparative example in table 1 at different wave bands, and L11 to L15 are reflectivity curves of the auxiliary functional layer (MOF) 4 corresponding to the first to fifth examples in table 1 at different wave bands, respectively.

**Table 1 Correspondence between auxiliary functional layer (MOF) 4 and R/G/B reflectivity**

| Example | Number of MOF layers | Value of n in each layer | Thickness of each film layer (µm) | R reflectivity/ % | G reflectivity/ % | B reflectivity/ % |
|---|---|---|---|---|---|---|
| Comparative example | - | - | - | 21 | 20 | 10 |
| First Example | 4 | 1.8/1.5/1.8/1.5 | 1.0/1.0/1.0/1.0 | 54.3% | 47.9% | 6.0% |
| Second Example | 6 | 1.85/1.45/1.85/1.45/1.85 | 1.5/1.0/1.5/1.0/1.5/1.0 | 68.8% | 58.5% | 5.5% |
| Third Example | 8 | 1.9/1.4/1.9/1.4/1.9/1.4/1.9/1. 4 | 2.0/1.0/2.0/1.0/2.0/1.0/2.0/ 1.0 | 83.9% | 71.6% | 4.4% |
| Fourth Example | 8 | 1.95/1.3/1.95/1.3/1.95/1.3/1. 95/1.3 | 2.0/1.0/2.0/1.0/2.0/1.0/2.0/ 1.0 | 92.4% | 84.0% | 3.2% |
| Fifth Example | 8 | 1.95/1.2/1.95/1.2/1.95/1.2/1. 95/1.2 | 1.5/1.0/1.5/1.0/1.5/1.0/1.5/ 1.0 | 99.1% | 90% | 0.3% |

According to the comparison of the examples and the comparative example in table 1 and FIG. 7, the R/G reflectivities are increased while the B reflectivity is reduced, indicating that the addition of the MOF4 contributes to increased reflection to the R/G emitted light. In the fifth example, the R/G reflectivities are respectively 99.1% and 90%, close to total reflection, indicating that the MOF4 corresponding to the fifth example can effectively reduce the downward R/G emitted light reaching the surface of the touch detection layer 1, and avoid interference with detection of the touch detection layer 1, thereby improving the accuracy and sensitivity of the touch detection layer 1. Meanwhile, as the R/G light emitted from the MOF4 is reflected, the light extraction on a front surface of the display product can be improved, thereby increasing the efficiency of the QD-OLED device. Meanwhile, the reflectivity of blue light in the fifth example is 0.3%, which means that almost all blue light is transmitted, which can further increase the efficiency of the device.

In some embodiments, the display substrate includes a first subpixel, a second subpixel, and a third subpixel which emit the first color light, the second color light, and the third color light, respectively. The first subpixel includes one light-emitting device 2; the second subpixel includes one light-emitting device 2 and one first quantum dot unit 301; and the third subpixel includes one light-emitting device 2 and one second quantum dot unit 302.

Specifically, with continued reference to FIG. 3, the light-emitting device 2 is disposed in correspondence with the first quantum dot unit 301 or the second quantum dot unit 302. With such arrangement, the first color light emitted from each light-emitting device 2 can better excite the first quantum dot unit 301 and the second quantum dot unit 302 in the quantum dot layer 3 to emit light of corresponding colors.

In some embodiments, the display substrate includes not only the base substrate 101, the light-emitting device layer, the quantum dot layer 3, the touch detection layer 1, the auxiliary functional layer 4, and the encapsulation layer 201, but also a light blocking layer 5 on a side of the auxiliary functional layer 4 facing away from the base substrate 101. The light blocking layer 5 includes a first receiving portion configured to transmit the first color light emitted from the light-emitting device 2 in the first subpixel, a second receiving portion configured to receive the first quantum dot unit 301, a third receiving portion configured to receive a second quantum dot unit 302, and a first blocking part defining the first, second, and third receiving portions; and the first blocking part has at least one first opening running through in a thickness direction thereof.

Specifically, for the interference light ①, ② and ③ in FIG. 2, the second color light and the third color light can be reflected by the auxiliary functional layer 4 on the display substrate, so that interference of ① and ② with the touch detection layer 1 can be reduced. For the first color light ③ and ⑤, ③ is interference light that may interfere with the touch detection layer 1, and ⑤ is valid reflected light generated based on touch. The two have the same color and a substantially constant wavelength, but may generate different spectrums of light after passing through different light paths.

Taking ③ and ⑤ in FIG. 2 as an example, blue light typically has a spectrum between 480nm and 485nm, but ③ is obtained by blue light emitted below the quantum dot layer 3, i.e., emitted downward; while ⑤ is obtained by blue light which passes through the quantum dot layer 3 to the screen, experiences a first reflection at a touch position, and then passes through the quantum dot layer 3 again. In some embodiments, the first receiving portion receives the scattering particle unit which is configured to scatter the first color light. As a result, ③ is emitted below the quantum dot layer 3, i.e., emitted downward, while ⑤ passes through the quantum dot layer 3 twice and the light is fully scattered by the scattering particle unit, causing the spectrum of ⑤ to become about 450nm. Therefore, the spectrum of ③ is still about 480nm to 485nm, while the spectrum of ⑤ is reduced. Based on the different spectrums of the two, a first blocking part material suitable for the light blocking layer 5 is selected such that the first blocking part of the light blocking layer 5 absorbs only interference light in the first color light (e.g., ③), while a first opening is formed in the first blocking part to allow valid light in the first color light (e.g., ⑤) to pass through, so that the touch detection layer 1 detects the touch signal. One or more first openings may be provided. The first opening may be disposed at any position of the first blocking part as long as the first opening can transmit light reflected at the touch position.

In some embodiments, the display substrate is divided into a plurality of pixel units arranged in an array, each of which includes one first subpixel, one second subpixel and one third subpixel; and an opening region is defined between any four pixel units arranged in an array, in which the first opening is located.

Specifically, the first subpixel may be a blue subpixel, the second subpixel may be a red subpixel, and the third subpixel may be a green subpixel. First openings at different positions may have different transmission effects on the light reflected at the touch position (e.g., ⑤ in FIG. 2), and different arrangement modes of the pixel units may also affect the transmission effect on the light reflected at the touch position (e.g., ⑤ in FIG. 2). In the embodiment of the present disclosure, by defining the opening region based on the arrangement of the pixel units and providing the first opening in the opening region, the light reflected at the touch position can be better transmitted through the first opening, thereby improving the accuracy and sensitivity of the touch detection layer 1.

In some embodiments, an orthographic projection of the first opening on the base substrate 101 may have a polygonal shape like a quadrangle, a triangle or a hexagon, or may have a circular shape, and the specific shape of the first opening is not limited in the present disclosure.

In some embodiments, a plurality of first openings are provided on the base substrate 101 in a centrosymmetric manner with respect to a center of the opening region. With such arrangement, the first color light transmitted to the touch detection layer 1 through the first openings can be more uniform, so that more accurate detection can be obtained.

In some embodiments, in a case where orthographic projections of the first, second and third receiving portions on the base substrate 101 each have an octagonal shape, an orthographic projection of the opening region on the base substrate 101 has a regular decagonal shape, with the first opening provided at at least one of a center, a center of a side, a vertex, a midpoint of a connection line between the vertex and the center, or a midpoint of a connection line between the center of the side and the center, of the regular decagonal shape.

Specifically, the fact that the orthographic projections of the first, second and third receiving portions on the base substrate 101 each have an octagonal shape means that orthographic projections of the first subpixel, the second subpixel and the third subpixel on the base substrate 101 also have an octagonal shape.

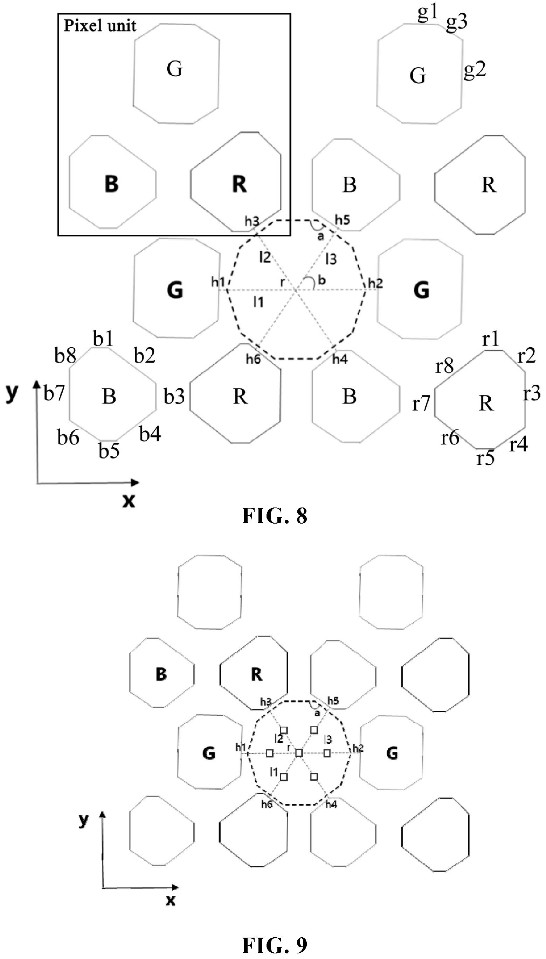

FIG. 8 is a schematic diagram showing an arrangement of pixel units according to an embodiment of the present disclosure.

In FIG. 8, the case where the first subpixel is a blue subpixel B, the second subpixel is a red subpixel R, and the third subpixel is a green subpixel G is taken as an example to illustrate the specific shapes of the orthographic projections of the first subpixel, the second subpixel and the third subpixel on the base substrate 101.

As shown in FIG. 8, the green subpixel G includes two first sides g1, two second sides g2 and four third sides g3. The two first sides g1 are arranged in parallel in a first direction, the two second sides g2 are arranged in parallel in a second direction, and the first sides g1 and the second sides g2 are sequentially connected through the third sides g3. The blue subpixel B includes a fourth side b1, a fifth side b2, a sixth side b3, a seventh side b4, an eighth side b5, a ninth side b6, a tenth side b7 and an eleventh side b8 sequentially connected. The fourth side b1 and the eighth side b5 are arranged in parallel in the first direction, the sixth side b3 and the tenth side b7 are arranged in parallel in the second direction, and the sixth side b3 has a length smaller than the tenth side b7. The red subpixel R includes a twelfth side r1, a thirteenth side r2, a fourteenth side r3, a fifteenth side r4, a sixteenth side r5, a seventeenth side r6, an eighteenth side r7, and a nineteenth side r8 sequentially connected. The twelfth side r1 and the sixteenth side r5 are arranged in parallel in the first direction, the fourteenth side r3 and the eighteenth side r7 are arranged in parallel in the second direction, and the fourteenth side r3 has a length larger than the eighteenth side r7.

In some embodiments, the green subpixel may have an aperture ratio of 1.8 to 2.0; the red subpixel may have an aperture ratio of 1.4 to 1.6; and a ratio of aperture ratios of the green subpixel, the red subpixel and the blue subpixel satisfies: 1.8:1.6:1≤x≤2.0:1.4:1. With such arrangement, the requirement of light passing can be met. The specific sizes of the green, red and blue subpixels are not limited in the present disclosure, as long as the above aperture ratio requirement is satisfied.

In a case where orthographic projections of the first, second and third receiving portions on the base substrate 101 each have an octagonal shape, an orthographic projection of the opening region on the base substrate 101 has a regular decagonal shape.

Specifically, still referring to FIG. 8, an opening region defined by any four pixel units arranged in an array will be described in detail below. For any four pixel units arranged in an array, i.e.: a first pixel unit, a second pixel unit, a third pixel unit, and a fourth pixel unit, the first pixel unit and the second pixel unit are arranged in a first direction x, the third pixel unit and the fourth pixel unit are arranged in the first direction x, and the first pixel unit and the third pixel unit are arranged in a second direction y. To better match the design layout of the pixel units, a range of the opening region is set as the dashed region in FIG. 8, where the opening region has an equilateral decagonal shape, and an angle a between two adjacent sides is (n-2) × 180°/10=144°. The specific relative positional relationship between the opening region and the four pixel units arranged in an array will be described below.

Specifically, as shown in FIG. 8, given that a distance from a vertex of the angle between two adjacent sides of the decagonal shape to a center of the decagon is r, a straight line l1 is drawn parallel to the first direction x, and intersected with edges of the two green subpixels G in the third pixel unit and the fourth pixel unit at points h1 and h2; where a distance H1 is provided between the point h1 and the green subpixel G in the third pixel unit, and a distance H2 is provided between the point h2 and the green subpixel G in the fourth pixel unit.

A straight line l2 is drawn by rotating clockwise by 60° from the first direction x, and intersected with edges of the red subpixel R in the first pixel unit and the blue subpixel B in the fourth pixel unit at points h3 and h4; where a distance H3 is provided between the point h3 and the red subpixel R in the first pixel unit, and a distance H4 is provided between the point h4 and the blue subpixel B in the fourth pixel unit.

A straight line l3 is drawn by rotating clockwise by 120° from the first direction x, and intersected with edges of the blue subpixel B in the second pixel unit and the red subpixel R in the third pixel unit at points h5 and h6; where a distance H5 is provided between the point h5 and the blue subpixel B in the second pixel unit, and a distance H6 is provided between the point h6 and the red subpixel R in the third pixel unit.

In some embodiments, (1/10)r≤H1=H2≤(1/4)r, and (1/10)r≤H3, H4, H5, H6≤(1/5)r. In some embodiments, H3 may be equal to or different from H4. In some embodiments, H5 may be equal to or different from H6.

In some embodiments, a distance r from the center to any vertex of the regular decagonal shape is in a range from 20µm to 50µm.

In some embodiments, the decagonal shape has an area in a range from (1/5)S to S, where S is an area of an orthographic projection of a single pixel unit on the base substrate 101. The area of the orthographic projection of a single pixel unit on the base substrate 101 refers to a summed area of orthographic projections of contours each formed by connecting edges of the first subpixel, the second subpixel or the third subpixel on the base substrate 101.

In some embodiments, an orthographic projection of each first opening on the base substrate 101 has an area in a range from (1/60)S to (1/14)S; and for first openings in one opening region, a total area of orthographic projections of the first openings on the base substrate is in a range from (1/8)S to (1/2)S. With such arrangement, the first opening can meet the transmission requirement of the first color light, so that the touch detection layer 1 detects the received optical signal.

FIGs. 9 to 11 are schematic diagrams showing a layout of first openings according to an embodiment of the present disclosure. FIGs. 9 to 11 are schematic diagrams illustrating a layout of first openings in a case where orthographic projections of the first, second and third receiving portions on the base substrate 101 each have an octagonal shape, and an orthographic projection of the opening region on the base substrate 101 has a regular decagonal shape.

In FIG. 9, first openings are provided at a center of the opening region, a midpoint of a connection line between the center and a vertex of the opening region, and a midpoint of a connection line between the center and a center of a side of the opening region, and located on l1, l2 and l3. In some embodiments, an orthographic projection of each first opening on the base substrate 101 has an area in a range from (1/60)S to (1/14)S; and for first openings in one opening region, a total area of orthographic projections of the first openings on the base substrate is in a range from (1/8)S to (1/2)S. With such arrangement, the first opening can meet the transmission requirement of the first color light, so that the touch detection layer 1 detects the received optical signal.

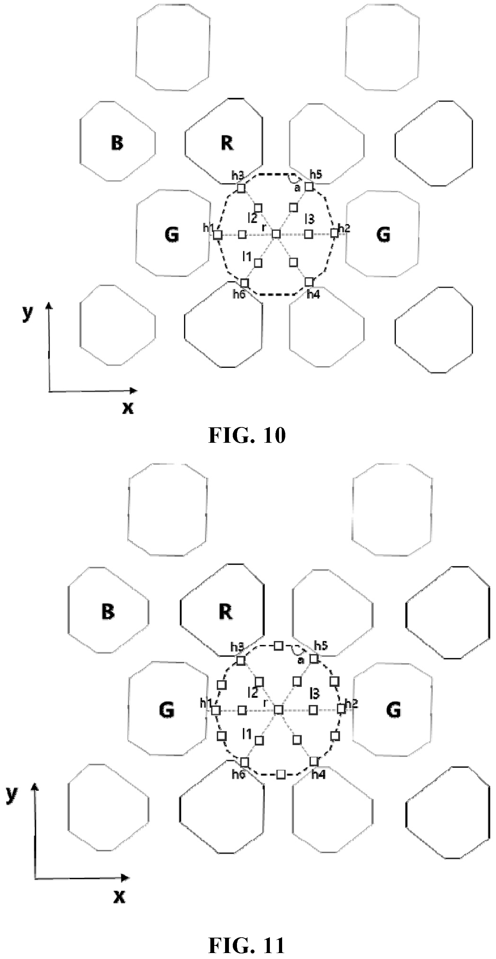

In FIG. 10, on the basis of the embodiment corresponding to FIG. 9, first openings are further provided at midpoints of some sides and vertexes of the opening region, and located on l1, l2 and l3. In some embodiments, an orthographic projection of each first opening on the base substrate 101 has an area in a range from (1/60)S to (1/20)S; and for first openings in one opening region, a total area of orthographic projections of the first openings on the base substrate is in a range from (1/6)S to (1/2)S. As the number of first openings increases, the area of the orthographic projection of each first opening on the base substrate 101 is gradually reduced, while for first openings in one opening region, the total area of orthographic projections of the first openings on the base substrate is gradually increased. With such arrangement, the first opening can meet the transmission requirement of the first color light, so that the touch detection layer 1 detects the received optical signal.

In FIG. 11, on the basis of the embodiment corresponding to FIG. 10, first openings are provided at centers of the remaining sides of the opening region. In some embodiments, an orthographic projection of each first opening on the base substrate 101 has an area in a range from (1/60)S to (1/40)S; and for first openings in one opening region, a total area of orthographic projections of the first openings on the base substrate is in a range from (1/4)S to (1/2)S. Compared with the embodiment corresponding to FIG. 10, the area of the orthographic projection of each first opening on the base substrate 101 is further reduced, while for first openings in one opening region, the total area of orthographic projections of the first openings on the base substrate is increased. With such arrangement, the first opening can meet the transmission requirement of the first color light, so that the touch detection layer 1 detects the received optical signal.

In the embodiments corresponding to FIGs. 9 to 11, although only the case where the orthographic projection of the first opening on the base substrate 101 may be set to have a quadrangle shape is taken as an example for illustration, it will be understood that the orthographic projection of the first opening on the base substrate 101 may alternatively have other polygonal shapes like a triangle or a hexagon, or may have a circular shape, and the specific shape of the first opening is not limited in the present disclosure. Apparently, the first opening may be also disposed at other positions of the opening region, which is not limited in the present disclosure.

In some embodiments, in a case where orthographic projections of the first, second and third receiving portions on the base substrate 101 each have a rectangular shape, an orthographic projection of the opening region on the base substrate 101 has a square shape, with the first opening provided at at least one of a center, a vertex, a center of a side, a midpoint of a connection line between the vertex and the center, a midpoint of a connection line between the vertex and the center of the side, or a midpoint of a connection line between of the center and the center of the side, the square shape.

Specifically, in a case where orthographic projections of the first, second and third receiving portions on the base substrate 101 each have a rectangular shape, orthographic projections of the first subpixel, the second subpixel and the third subpixel on the base substrate 101 also have a rectangular shape.

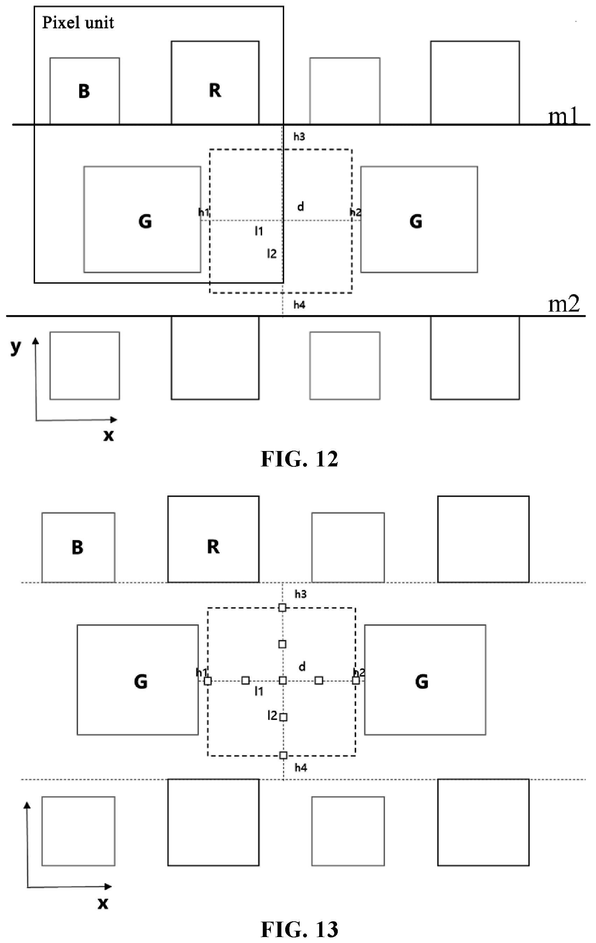

FIG. 12 is a schematic diagram showing another arrangement of pixel units according to an embodiment of the present disclosure.

In FIG. 12, the case where the first subpixel is a blue subpixel B, the second subpixel is a red subpixel R, and the third subpixel is a green subpixel G is taken as an example to illustrate the specific shapes of the orthographic projections of the first subpixel, the second subpixel and the third subpixel on the base substrate 101.

As shown in FIG. 12, orthographic projections of the blue subpixel B, the red subpixel R and the green subpixel G on the base substrate 101 each have a square shape, and have areas S1, S2, and S3, respectively, where S1 < S2 < S3. In some embodiments, the green subpixel may have an aperture ratio of 1.8 to 2.0; the red subpixel may have an aperture ratio of 1.4 to 1.6; and a ratio of aperture ratios of the green subpixel, the red subpixel and the blue subpixel satisfies: 1.8:1.6:1≤x≤2.0:1.4:1. With such arrangement, the requirement of light passing can be met. The specific sizes of the green, red and blue subpixels are not limited in the present disclosure, as long as the above aperture ratio requirement is satisfied.

In a case where orthographic projections of the first, second and third receiving portions on the base substrate 101 each have a rectangular shape, an orthographic projection of the opening region on the base substrate 101 has a square shape.

Specifically, still referring to FIG. 12, an opening region defined by any four pixel units arranged in an array will be described in detail below. For any four pixel units arranged in an array, i.e.: a fifth pixel unit, a sixth pixel unit, a seventh pixel unit, and an eighth pixel unit, the fifth pixel unit and the sixth pixel unit are arranged in a first direction x, the seventh pixel unit and the eighth pixel unit are arranged in the first direction x, and the fifth pixel unit and the seventh pixel unit are arranged in a second direction y. To better match the design layout of the pixel units, a range of the opening region is set as the dashed region in FIG. 12, where the opening region has a square shape. The specific relative positional relationship between the opening region and the four pixel units arranged in an array will be described below.

Specifically, as shown in FIG. 12, a straight line l1 is drawn parallel to the first direction x and passing through a center of the opening region, and intersected with edges of the two green subpixels G in the fifth pixel unit and the sixth pixel unit at points h1 and h2; where a distance H1 is provided between the point h1 and the green subpixel G in the fifth pixel unit, and a distance H2 is provided between the point h2 and the green subpixel G in the sixth pixel unit. A straight line l2 is drawn parallel to the second direction y and passing through a center of the opening region, intersected with a straight line m1 where an edge of the red subpixel R in the fifth pixel unit close to the green subpixel G therein is located at h3, and intersected with a straight line m2 where an edge of the red subpixel R in the seventh pixel unit facing away from the green subpixel G therein is located at h4. A distance H3 is provided between the point h3 and the straight line m1, and a distance H4 is provided between the point h4 and the straight line m2.

In some embodiments, (1/10)d≤H1=H2≤(1/5)d, and (1/8)d≤H3=H4≤(1/4)d, where d is a side length of the opening region (square).

In some embodiments, the square shape has a side length between 40µm and 120µm.

In some embodiments, the square shape has an area in a range from (1/4)S to S, where S is an area of an orthographic projection of a single pixel unit on the base substrate 101. The area of the orthographic projection of a single pixel unit on the base substrate 101 refers to a summed area of orthographic projections of contours each formed by connecting edges of the first subpixel, the second subpixel or the third subpixel on the base substrate 101.

In some embodiments, an orthographic projection of each first opening on the base substrate 101 has an area in a range from (1/100)S to (1/20)S; and for first openings in one opening region, a total area of orthographic projections of the first openings on the base substrate 101 is in a range from (1/8)S to (1/2)S. With such arrangement, the first opening can meet the transmission requirement of the first color light, so that the touch detection layer 1 detects the received optical signal.

FIGs. 13 to 15 are schematic diagrams of still another layout of first openings according to an embodiment of the present disclosure, respectively. FIGs. 13 to 15 are schematic diagrams illustrating a layout of first openings in a case where orthographic projections of the first, second and third receiving portions on the base substrate 101 each have a rectangular shape, and an orthographic projection of the opening region on the base substrate 101 has a square shape.

In FIG. 13, first openings are provided at a center of the opening region, a midpoint of a connection line between the center and a center of each side of the opening region, and the center of each side, and located on l1, l2 and l3. In some embodiments, an orthographic projection of each first opening on the base substrate 101 has an area in a range from (1/80)S to (1/20)S; and for first openings in one opening region, a total area of orthographic projections of the first openings on the base substrate 101 is in a range from (1/8)S to (1/2)S. With such arrangement, the first opening can meet the transmission requirement of the first color light, so that the touch detection layer 1 detects the received optical signal.

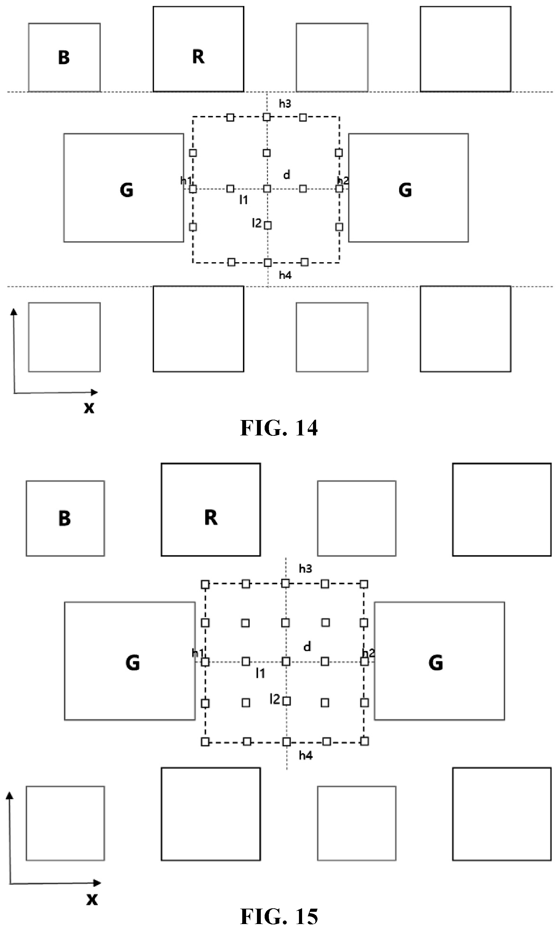

In FIG. 14, on the basis of the embodiment corresponding to FIG. 13, first openings are further provided at midpoints of connection lines between centers of the sides and vertexes of the opening region. In some embodiments, an orthographic projection of each first opening on the base substrate 101 has an area in a range from (1/80)S to (1/40)S; and for first openings in one opening region, a total area of orthographic projections of the first openings on the base substrate is in a range from (1/4)S to (1/2)S. As the number of first openings increases, the area of the orthographic projection of each first opening on the base substrate 101 is gradually reduced, while for first openings in one opening region, the total area of orthographic projections of the first openings on the base substrate is gradually increased. With such arrangement, the first opening can meet the transmission requirement of the first color light, so that the touch detection layer 1 detects the received optical signal.

In FIG. 15, on the basis of the embodiment corresponding to FIG. 14, first openings are also provided at vertexes of the opening region and midpoints of connection lines between the vertexes and the center. In some embodiments, an orthographic projection of each first opening on the base substrate 101 has an area in a range from (1/100)S to (1/50)S; and for first openings in one opening region, a total area of orthographic projections of the first openings on the base substrate is in a range from (1/3)S to (1/2)S. Compared with the embodiment corresponding to FIG. 14, the area of the orthographic projection of each first opening on the base substrate 101 is further reduced, while for first openings in one opening region, the total area of orthographic projections of the first openings on the base substrate is increased. With such arrangement, the first opening can meet the transmission requirement of the first color light, so that the touch detection layer 1 detects the received optical signal.

In the embodiments corresponding to FIGs. 13 to 15, although only the case where the orthographic projection of the first opening on the base substrate 101 may be set to have a quadrangle shape is taken as an example for illustration, it will be understood that the orthographic projection of the first opening on the base substrate 101may alternatively have other polygonal shapes like a triangle or a hexagon, or may have a circular shape, and the specific shape of the first opening is not limited in the present disclosure. Apparently, the first opening may be also disposed at other positions of the opening region, which is not limited in the present disclosure.

In the display substrate according to the embodiments of the present disclosure, by providing the four pixel units arranged in an array and defining the opening region, and providing the first opening in the opening region, the display substrate can absorb the first color light (e.g., ③ in FIG. 2) directly emitted from the quantum dot layer to the touch detection layer 1 and thus reduce the interference with the touch detection layer 1, while ensuring that the light reflected by touch (e.g., ⑤ in FIG. 2) can pass through the corresponding film layer to the touch detection layer 1 for detection. In addition, based on different arrangement modes of the pixel units, the opening region defined by the four pixel units arranged in an array may have different positions and shapes; and for different opening regions, different positions, numbers and shapes of first openings may be provided.

In some embodiments, the light-emitting device layer includes not only a plurality of light-emitting devices 2, but also a pixel defining layer 6. The pixel defining layer 6 is a light-shielding layer, including a fourth receiving portion and a second blocking part defining the fourth receiving portion. The second blocking part has a second opening arranged in one-to-one correspondence with the first opening.

Specifically, as shown in FIG. 3, the interference light (e.g., ③ in FIG. 2) of the first color light, which is emitted to the touch detection layer 1 through the quantum dot layer 3, and the valid light (e.g., ⑤ in FIG. 2) of the first color light, which is scattered by the scattering particle unit 303 and reflected by touch, then scattered by the scattering particle unit 303 again, and finally emitted to the touch detection layer 1, pass through different light paths and generate different spectrums of light. By setting the pixel defining layer 6 as a light-shielding layer, it is ensured that the pixel defining layer 6 can absorb the interference light of the first color light emitted to the touch detection layer 1 through the quantum dot layer 3, and meanwhile, by providing the second opening in the second blocking part of the pixel defining layer, it is ensured that the first color light reflected by touch can be emitted to the touch detection layer 1 to implement touch detection.

In some embodiments, the display substrate includes not only the base substrate 101, the light-emitting device layer, the quantum dot layer 3, the touch detection layer 1, the auxiliary functional layer 4, the encapsulation layer 201, and the light blocking layer 5, but also a color filter layer 8 on a side of the quantum dot layer 3 facing away from the light-emitting device layer. The color filter layer 8 includes a black matrix 801 and a color filter 802; and the black matrix 801 includes a light-transmitting part and a third blocking part defining the light-transmitting part. The third blocking part has a third opening arranged in one-to-one correspondence with the first opening.

Specifically, as shown in FIG. 3, by providing the third blocking part of the black matrix 801, it is ensured that the pixel defining layer 6 can absorb the interference light of the first color light emitted to the touch detection layer 1 through the quantum dot layer 3, and meanwhile, by providing the third opening in the third blocking part of the black matrix 801, it is ensured that the first color light reflected by touch can be emitted to the touch detection layer 1to implement touch detection.

It should be noted that the positions and shapes of the second and third openings are similar to those of the first opening, and thus are not repeated here. In addition, considering that in fact, the quantum dot layer 3 has the largest aperture ratio as compared with the color filter layer 8 and the pixels, and thus corresponds to the smallest area of light blocking layer 5, the sizes of the second and third openings may be appropriately increased compared to the size of the first opening when designing the black matrix 801 and the pixel defining layer 6. In some embodiments, a ratio of an area of the second opening on the base substrate 101 to an area of the first opening on the base substrate 101 is 1.0 to 1.1. In some embodiments, a ratio of an area of the third opening on the base substrate 101 to the area of the first opening on the base substrate 101 is 1.0 to 1.1.

In some embodiments, the display substrate further includes a scattering particle unit 303 received in the first receiving portion and configured to scatter the first color light.

Specifically, as shown in FIG. 3, the scattering particle unit 303 is disposed in the same layer as the first quantum dot unit 301 and the second quantum dot unit 302, and the scattering particle unit 303 emits the first color light. The first quantum dot unit 301 is typically a red quantum dot unit, the second quantum dot unit 302 is typically a green quantum dot unit, and the first color light is blue light. Light emitted from the red and green quantum dots is uniform and satisfies Lambertian distribution. In contrast, the blue light belongs to strong microcavity structures before any scattering particle is generated, where the strongest light field distribution occurs in a vertical direction, and is rapidly weakened with increase of the viewing angle. Therefore, to match the light field distribution of the quantum dots, the light field distribution above the blue light has to be changed to approximately Lambertian distribution by the scattering particle unit 303. In some embodiments, a solid content of scattering particles in the scattering particle unit 303 is typically set to 1% to 10%. In some embodiments, the scattering particle unit 303 may have a single-layer or multi-layer structure, and in a case where the scattering particle unit 303 has a multi-layer structure, the solid content of scattering particles in the scattering particle unit 303 may vary, and may be specifically and flexibly set according to the actual requirements.

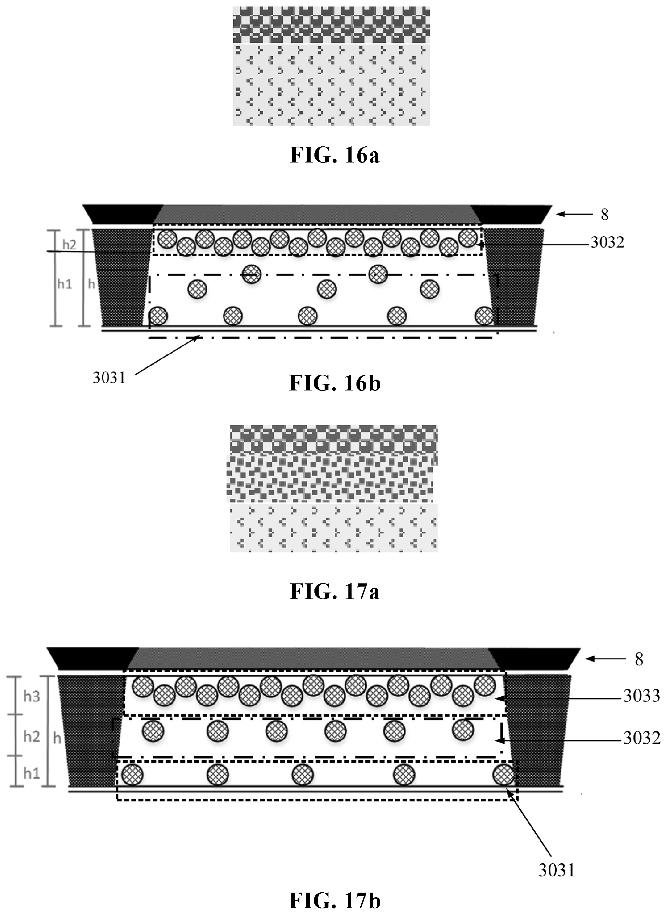

FIGs. 16a to 16b are schematic diagrams of a scattering particle unit according to an embodiment of the present disclosure.

In some embodiments, the scattering particle unit 303 includes a first scattering particle unit 3031 and a second scattering particle unit 3032 sequentially arranged in a direction facing away from the touch detection layer 1. A solid content of scattering particles in the first scattering particle unit 3031 is in a range from 1% to 2%; and a solid content of scattering particles in the second scattering particle unit 3032 is in a range from 4% to 8%.

Specifically, as shown in FIGs. 16a to 16b, the scattering particle unit 303 includes a two-layer scattering particle structure. A film layer at an end of the scattering particle unit 303 close to the color filter layer 8 has a solid content of scattering particles higher than a film layer at an end close to the auxiliary functional layer. With such arrangement, on one hand, it is ensured that in a direction pointing from the base substrate to the screen, the first color light is uniformly scattered, so that a proportion of the first color light passing through the scattering particle unit 303 upwards to the screen is increased, thereby increasing the emission brightness of the screen. On the other hand, in a direction pointing from the light-emitting device layer to the touch detection layer 1, the proportion of the first color light passing through the scattering particle unit 303 and emitted downward to the touch detection layer 1 is further reduced, thereby reducing the interference with the touch detection layer 1. In addition, specific values of the solid contents of scattering particles in the first scattering particle unit 3031 and the second scattering particle unit 3032 may be set based on the specific situations, which are not limited in the present disclosure.

In some embodiments, the scattering particle unit 303 includes a first scattering particle unit 3031 and a second scattering particle unit 3032 sequentially arranged in a direction facing away from the touch detection layer 1. A thickness of the first scattering particle unit 3031 is in a range from (1/2)h to (4/5)h; and a thickness of the second scattering particle unit 3032 is in a range from (1/5)h to (1/2)h, where h is a total thickness of the scattering particle unit 303.

Specifically, as shown in FIGs. 16a to 16b, the scattering particle unit 303 includes a two-layer scattering particle structure. Optionally, a total film thickness of the scattering particle unit 303 is in a range from 10µm to 15µm, where a film thickness of the second scattering particle unit 3032 close to an end of the color filter layer 8 is h2, a film thickness of the first scattering particle unit 3031 close to an end of the auxiliary functional layer below is h1, and it is set that (1/2)h≤h1≤(4/5)h, and (1/5)h≤h2≤(1/2)h. With such arrangement, on one hand, it is ensured that in a direction pointing from the base substrate to the screen, the first color light is uniformly scattered, so that a proportion of the first color light passing through the scattering particle unit 303 upwards to the screen is increased, thereby increasing the emission brightness of the screen. On the other hand, in a direction pointing from the light-emitting device layer to the touch detection layer 1, the proportion of the first color light passing through the scattering particle unit 303 and emitted downward to the touch detection layer 1 is further reduced, thereby reducing the interference with the touch detection layer 1.

FIGs. 17a to 17b are schematic diagrams of another scattering particle unit according to an embodiment of the present disclosure.

In some embodiments, the scattering particle unit 303 includes a first scattering particle unit 3031, a second scattering particle unit 3032, and a third scattering particle unit 3033 sequentially arranged in a direction facing away from the touch detection layer 1. A solid content of scattering particles in the first scattering particle unit 3031 is in a range from 1% to 2%; a solid content of scattering particles in the second scattering particle unit 3032 is in a range from 2% to 4%; and a solid content of scattering particles in the third scattering particle unit 3033 is in a range from 4% to 6%.

In some embodiments, the scattering particle unit 303 includes a first scattering particle unit 3031, a second scattering particle unit 3032, and a third scattering particle unit 3033 sequentially arranged in a direction facing away from the touch detection layer 1. A thickness of the first scattering particle unit 3031 is in a range from (1/3)h to (1/2)h; a thickness of the second scattering particle unit 3032 is in a range from (1/6)h to (1/3)h; and a thickness of the third scattering particle unit 3033 is in a range from (1/3)h to (1/2)h, where h is a total thickness of the scattering particle unit 303.

Specifically, as shown in FIGs. 17a to 17b, the scattering particle unit 303 may alternatively be provided as a three-layer structure. A film layer at an end of the scattering particle unit 303 close to the color filter layer 8 has a solid content of scattering particles higher than an end close to the auxiliary functional layer below. Therefore, the proportion of the first color light passing through the scattering particle unit 303 and emitted downward to the touch detection layer 1 is further reduced, and interference with the touch detection layer 1 is reduced. Optionally, the scattering particle unit 303 has a total film thickness h, where h is generally set between 10µm and 15µm. The third scattering particle unit 3033 has a film thickness h3, where (1/3)h≤h3≤(1/2)h, and the solid content is in a range from 4% to 6%. The second scattering particle unit 3032 has a film thickness h2, where (1/6)h≤h2≤(1/3)h, and the solid content is in a range from 2% to 4%. The first scattering particle unit 3031 has a film thickness h1, where (1/3)h≤h1≤(1/2)h, and the solid content is in a range from 1% to 2%.

The scattering particle unit 303 may include more or less structures, and embodiments of other structures of the scattering particle unit 303 are not illustrated here.

In some embodiments, the display substrate includes not only the base substrate 101, the light-emitting device layer, the quantum dot layer 3, the touch detection layer 1, the auxiliary functional layer 4, the encapsulation layer 201, and the light blocking layer 5, but also an optical clear adhesive unit 304, and the first receiving portion is configured to receive the optical clear adhesive unit 304.

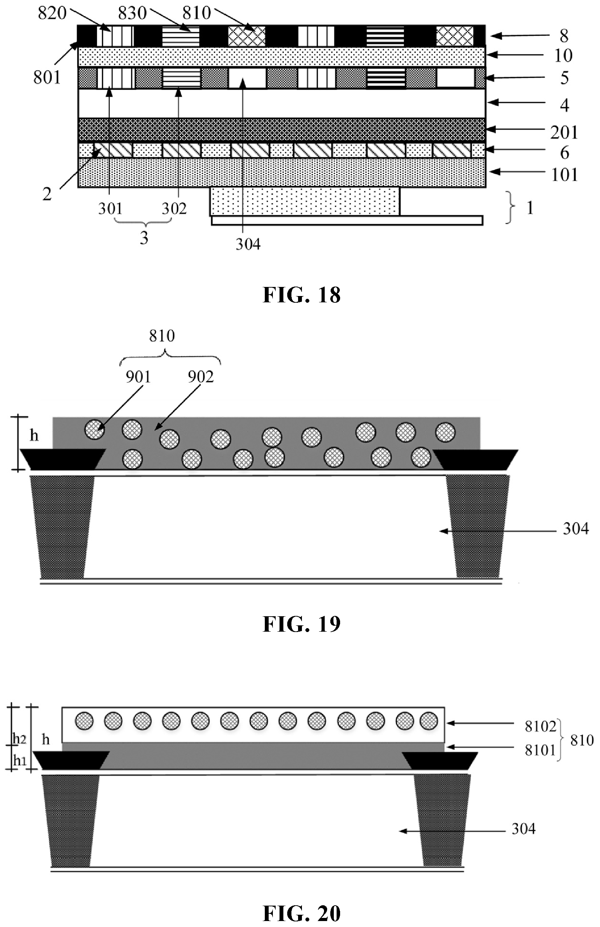

Specifically, FIG. 18 is a schematic diagram of another display substrate according to an embodiment of the present disclosure. As shown in FIG. 18, the optical clear adhesive unit 304 is disposed in the same layer as the first quantum dot unit 301 and the second quantum dot unit 302. It differs from the display substrate corresponding to FIG. 3 in that a transparent optical clear adhesive unit 304 is provided in place of the scattering particle unit 303 in FIG. 3, so that the first color light passes through the optical clear adhesive unit 304 to be emitted upward.

In some embodiments, the display substrate includes not only the base substrate 101, the light-emitting device layer, the quantum dot layer 3, the touch detection layer 1, the auxiliary functional layer 4, the encapsulation layer 201, the light blocking layer 5, and the optical clear adhesive unit 304, but also a color filter layer 8 on a side of the quantum dot layer 3 facing away from the light-emitting device layer. The color filter layer 8 includes a black matrix 801 and a first structure 810, a second color filter 820 and a third color filter 830. The second color filter 820 is arranged in one-to-one correspondence with the first quantum dot unit 301; the third color filter 830 is arranged in one-to-one correspondence with the second quantum dot unit 302; the first structure 810 is arranged in one-to-one correspondence with the optical clear adhesive unit 304; and the first structure 810 is further configured to scatter the first color light.

Specifically, as shown in FIG. 18, it differs from the display substrate corresponding to FIG. 3 in that a transparent optical clear adhesive unit 304 is provided in place of the scattering particle unit 303 in FIG. 3, and scattering particles are provided in place of the first color filter in FIG. 3. With such arrangement, on one hand, the first color light can pass through the optical clear adhesive unit 304 to be emitted upward; and on the other hand, compared with the embodiment shown in FIG. 3, the scattering particles are further away from the touch detection layer 1, so that a proportion of the first color light emitted from the quantum dot layer and directly scattered to the touch detection layer 1 through the scattering particles can be reduced, and interference with the touch detection layer is reduced, while in a direction pointing from the base substrate to the screen, there is a certain scattering effect on the first color light.

In some embodiments, the first structure 810 is made of a mixture of a material of a first color filter and a material of scattering particles, and a solid content of the scattering particles is in a range from 6% to 8%.

Specifically, FIG. 19 is a schematic diagram of a first structure according to an embodiment of the present disclosure. As shown in FIG. 19, the first structure 810 is composed of scattering particles 901 and a first color filter pattern 902, where the scattering particles 901 are directly mixed in a photoresist of the first color filter pattern 902, and prepared by coating and exposing processes. In some embodiments, the first structure 810 has a film thickness h set to 3µm to 5µm, and a solid content set to 6% to 8%. With such arrangement, scattering of the first color light can be satisfied.

In some embodiments, the first structure 810 includes a first color filter unit 8101 and a scattering particle unit 8102 sequentially arranged in a direction facing away from the quantum dot layer 3.

In some embodiments, a thickness of the scattering particle unit 8102 is greater than or equal to a thickness of the first color filter unit 8101.

Specifically, FIG. 20 is a schematic diagram of another first structure according to an embodiment of the present disclosure. As shown in FIG. 20, for the first structure 810, the first color filter unit 8101 may be prepared first, and then the scattering particle unit 8102 may be prepared thereon. In some embodiments, the first structure has a total film thickness h set to 4µm to 6µm, where a film thickness h1 of the first color filter unit 8101 should be greater than a thickness of the black matrix 801. The film thickness h1 of the first color filter unit 8101 is set to: (1/3)h≤h1≤(1/2)h; and the film thickness h2 of the scattering particle unit 8102 should be greater than or equal to the film thickness of the first color filter unit 8101, and set to: (1/2)h≤h2≤(2/3)h.

In the display substrate provided in the embodiments of the present disclosure, in a first aspect, to optimize light emitted downward from the first quantum dot unit 301 and the second quantum dot unit 302 (i.e., R/G QD), an auxiliary functional layer 4 is adopted, so that the reflectivities of the auxiliary functional layer 4 to the second color light R and the third color light G are both improved, while the reflectivity to the first color light B is reduced, thereby effectively reducing the light emitted downward from the R/G QD and reaching the surface of the touch detection layer 1, and improving the detection accuracy and sensitivity of the touch detection layer 1. Meanwhile, as the second color light R and the third color light G emitted downward are reflected, the light extraction on a front surface of the display substrate can be improved, thereby increasing the efficiency of the display device. In a second aspect, to optimize light emitted downward from the scattering particle unit above the first color light B, different first, second and third openings are provided for different arrangement structures of pixel units in the embodiments of the present disclosure, so as to effectively reduce the light emitted downward from the R/G QD and reaching the surface of the touch detection layer 1, and improve the detection accuracy and sensitivity of the touch detection layer 1. In a third aspect, to optimize light emitted downward from the scattering particle layer above the first color light B, the structure and position of the scattering particle unit may be further adjusted in the embodiments of the present disclosure, and by designing of the film thickness of the scattering particle unit and setting the solid content, the light emitted downward from the R/G QD and reaching the surface of the touch detection layer 1 can be reduced, and the detection accuracy and sensitivity of the touch detection layer 1 can be improved.

Based on the same inventive concept, an embodiment of the present disclosure further provides a display substrate, including the display substrate as described in any of the above embodiments.

It will be appreciated that the above implementations are merely exemplary implementations for the purpose of illustrating the principle of the present disclosure, and the present disclosure is not limited thereto. Various modifications and improvements can be made by those skilled in the art without departing from the spirit and essence of the present disclosure. Accordingly, all of the modifications and improvements also fall into the protection scope of the present disclosure.

## Claims

1. A display substrate, comprising:
a base substrate;
a light-emitting device layer on the base substrate, wherein the light-emitting device layer comprises a plurality of light-emitting devices configured to emit first color light;
a quantum dot layer on a side of the light-emitting device layer facing away from the base substrate, wherein the quantum dot layer comprises at least a first quantum dot unit and a second quantum dot unit, where the first quantum dot unit is configured to emit second color light under excitation of the first color light, and the second quantum dot unit is configured to emit third color light under excitation of the first color light;
a touch detection layer on a side of the light-emitting device layer facing away from the quantum dot layer, and configured to determine touch information according to a received optical signal; and
an auxiliary functional layer between the quantum dot layer and the light-emitting device layer; wherein the auxiliary functional layer is configured to transmit the first color light and reflect the second color light and the third color light.

2. The display substrate according to claim 1, wherein an encapsulation layer is disposed on a side of the light-emitting device layer facing away from the base substrate, and the auxiliary functional layer is disposed between the encapsulation layer and the quantum dot layer.

3. The display substrate according to claim 1 or 2, wherein the auxiliary functional layer comprises a plurality of functional sub-layers sequentially stacked in a direction facing away from the base substrate, and in a direction pointing from the quantum dot layer to the base substrate, each functional sub-layer in an odd layer has a first refractive index, each functional sub-layer in an even layer has a second refractive index, and the first refractive index is higher than the second refractive index.

4. The display substrate according to claim 3, wherein the first refractive index is in a range from 1.85 to 1.95; and the second refractive index is in a range from 1.2 to 1.4.

5. The display substrate according to claim 3, wherein the functional sub-layer in the odd layer has a thickness in a range from 0.5µm to 2.0µm; and the functional sub-layer in the even layer has a thickness in a range from 1.0µm to 2.0µm.

6. The display substrate according to claim 1, wherein the display substrate comprises a first subpixel, a second subpixel, and a third subpixel which emit the first color light, the second color light, and the third color light, respectively, wherein the first subpixel comprises one light-emitting device; the second subpixel comprises one light-emitting device and one first quantum dot unit; and the third subpixel comprises one light-emitting device and one second quantum dot unit.

7. The display substrate according to claim 6, wherein the display substrate comprises a light blocking layer on a side of the auxiliary functional layer facing away from the base substrate, wherein the light blocking layer comprises a first receiving portion configured to transmit the first color light emitted from the light-emitting device in the first subpixel, a second receiving portion configured to receive the first quantum dot unit, a third receiving portion configured to receive the second quantum dot unit, and a first blocking part defining the first, second, and third receiving portions; and the first blocking part has at least one first opening running through the first blocking part in a thickness direction thereof.

8. The display substrate according to claim 7, wherein the display substrate is divided into a plurality of pixel units arranged in an array, each of which comprises one first subpixel, one second subpixel and one third subpixel; and an opening region is defined between any four pixel units arranged in an array, and the first opening is in the opening region.

9. The display substrate according to claim 8, wherein orthographic projections of the first, second and third receiving portions on the base substrate each have an octagonal shape, an orthographic projection of the opening region on the base substrate has a regular decagonal shape, with the first opening provided at at least one of a center, a center of a side, a vertex, a midpoint of a connection line between the vertex and the center, or a midpoint of a connection line between the center of the side and the center, of the regular decagonal shape.

10. The display substrate according to claim 9, wherein a distance from the center to any vertex of the regular decagonal shape is in a range from 20µm to 50µm.

11. The display substrate according to claim 9, wherein the regular decagonal shape has an area in a range from (1/5)S to S, where S is an area of an orthographic projection of a single pixel unit on the base substrate.

12. The display substrate according to claim 9, wherein an orthographic projection of each first opening on the base substrate has an area in a range from (1/60)S to (1/14)S; and for first openings in one opening region, a total area of orthographic projections of the first openings on the base substrate is in a range from (1/8)S to (1/2)S.

13. The display substrate according to claim 8, wherein orthographic projections of the first, second and third receiving portions on the base substrate each have a rectangular shape, an orthographic projection of the opening region on the base substrate has a square shape, with the first opening provided at at least one of a center, a vertex, a center of a side, a midpoint of a connection line between the vertex and the center, a midpoint of a connection line between the vertex and the center of the side, or a midpoint of a connection line between of the center and the center of the side, the square shape.

14. The display substrate according to claim 13, wherein the square shape has a side length in a range from 40µm to 120µm.

15. The display substrate according to claim 13, wherein the square shape has an area in a range from (1/4)S to S, where S is an area of an orthographic projection of a single pixel unit on the base substrate.

16. The display substrate according to claim 13, wherein an orthographic projection of each first opening on the base substrate has an area in a range from (1/100)S to (1/20)S; and for first openings in one opening region, a total area of orthographic projections of the first openings on the base substrate is in a range from (1/8)S to (1/2)S.

17. The display substrate according to any one of claims 7 to 16, wherein the light-emitting device layer comprises a pixel defining layer, which is a light-shielding layer, comprising a fourth receiving portion and a second blocking part defining the fourth receiving portion, wherein the second blocking part has a second opening arranged in one-to-one correspondence with the first opening.

18. The display substrate according to any one of claims 7 to 16, wherein the display substrate further comprises a color filter layer on a side of the quantum dot layer facing away from the light-emitting device layer, wherein the color filter layer comprises a black matrix and a color filter; and the black matrix comprises a light-transmitting part and a third blocking part defining the light-transmitting part, wherein the third blocking part has a third opening arranged in one-to-one correspondence with the first opening.

19. The display substrate according to claim 7, wherein the display substrate further comprises a scattering particle unit received in the first receiving portion and configured to scatter the first color light.

20. The display substrate according to claim 19, wherein the scattering particle unit comprises a first scattering particle unit and a second scattering particle unit sequentially arranged in a direction facing away from the touch detection layer, wherein a solid content of scattering particles in the first scattering particle unit is in a range from 1% to 2%; and a solid content of scattering particles in the second scattering particle unit is in a range from 4% to 8%.

21. The display substrate according to claim 19, wherein the scattering particle unit comprises a first scattering particle unit and a second scattering particle unit sequentially arranged in a direction facing away from the touch detection layer, wherein a thickness of the first scattering particle unit is in a range from (1/2)h to (4/5)h; and a thickness of the second scattering particle unit is in a range from (1/5)h to (1/2)h, where h is a total thickness of the scattering particle unit.

22. The display substrate according to claim 19, wherein the scattering particle unit comprises a first scattering particle unit, a second scattering particle unit, and a third scattering particle unit sequentially arranged in a direction facing away from the touch detection layer, wherein a solid content of scattering particles in the first scattering particle unit is in a range from 1% to 2%; a solid content of scattering particles in the second scattering particle unit is in a range from 2% to 4%; and a solid content of scattering particles in the third scattering particle unit is in a range from 4% to 6%.

23. The display substrate according to claim 19, wherein the scattering particle unit comprises a first scattering particle unit, a second scattering particle unit, and a third scattering particle unit sequentially arranged in a direction facing away from the touch detection layer, wherein a thickness of the first scattering particle unit is in a range from (1/3)h to (1/2)h; a thickness of the second scattering particle unit is in a range from (1/6)h to (1/3)h; and a thickness of the third scattering particle unit is in a range from (1/3)h to (1/2)h, where h is a total thickness of the scattering particle unit.

24. The display substrate according to claim 7, wherein the display substrate further comprises an optical clear adhesive unit received in the first receiving portion.

25. The display substrate according to claim 24, further comprising a color filter layer on a side of the quantum dot layer facing away from the light-emitting device layer, wherein the color filter layer comprises a black matrix and a first structure, a second color filter and a third color filter; the second color filter is arranged in one-to-one correspondence with the first quantum dot unit; the third color filter is arranged in one-to-one correspondence with the second quantum dot unit; the first structure is arranged in one-to-one correspondence with the optical clear adhesive unit; and
the first structure is further configured to scatter the first color light.

26. The display substrate according to claim 25, wherein the first structure is made of a mixture of a material of a first color filter and a material of scattering particles, and a solid content of the scattering particles is in a range from 6% to 8%.

27. The display substrate according to claim 25, wherein the first structure comprises a first color filter unit and a scattering particle unit sequentially arranged in a direction facing away from the quantum dot layer.

28. The display substrate according to claim 27, wherein a thickness of the scattering particle unit is greater than or equal to a thickness of the first color filter unit.

29. A display panel, comprising the display substrate according to any one of claims 1 to 28.
